# EUROPEAN PATENT SPECIFICATION

(11) **EP 0 983 533 B1**
(45) Date of publication and mention of the grant of the patent: **30.08.2006**
(21) Application number: 98922438.1
(22) Date of filing: 19.05.1998
(51) Int. Cl.: G03F 7/20, G03F 7/18, G03F 7/24

(54) **PRINTING SLEEVE AND METHOD OF MAKING USING DIGITAL IMAGING PHOTOPOLYMERIZATION**
DRUCKHÜLSE UND METHODE ZUR ERZEUGUNG EINER DRUCKHÜLSE MIT DIGITAL GESTEUERTER PHOTOPOLYMERISATION
MANCHON D'IMPRESSION ET PROCEDE DE FABRICATION DE CE MANCHON PAR PHOTOPOLYMERISATION D'IMAGERIE NUMERIQUE

(30) Priority: 19.05.1997 US 47035 P
(43) Date of publication of application: 08.03.2000
(73) Proprietor: DAY INTERNATIONAL INC., Dayton, OH 45401 (US)
(72) Inventor: MCLEAN, Michael, E., Waynesville, NC 28786 (US); WOLTERS, Dennis, R., Dayton, OH 45419 (US); BOHNSTADT, Allen, Mauldin, SC 29662 (US)
(74) Representative: Cummings, Sean Patrick
(86) International application number: PCT/US1998/010247
(87) International publication number: WO 1998/053370

(56) References cited:
- EP-A- 0 280 103
- EP-A- 0 491 368
- EP-A- 0 766 142
- WO-A-91/13511
- DE-A- 4 232 187
- US-A- 4 116 715
- ANONYMOUS: "Laser Direct Imaging System for Print Band Manufacturing" IBM TECHNICAL DISCLOSURE BULLETIN, vol. 27, no. 10B, March 1985, page 5970 XP002075588

## Description

### BACKGROUND OF THE INVENTION

The present invention relates to a printing sleeve and method of making it, and more particularly to such a printing sleeve having a relief image formed on its surface by digital imaging photopolymerization.

Flexography or flexographic printing are terms which have been applied broadly to a specialized form of relief printing which utilizes rubber or other elastomeric relief plates. Because the inks used for flexography dry very quickly, flexographic printing has been widely used to print a variety of nonabsorbent surfaces including plastics and foils as well as thick substrates such as paperboard. More recent improvements in the quality of the rubbery relief plates used in flexographic prirtting has broadened the types of jobs which are printed using this technique.

The rubbery relief plates used in flexography have been made in the past by castting or pressing a rubber sheet against a metal negative relief surface and then hardening the rubber. More recently, the plates have been manufactured using photohardenable polymeric compositions. Typically a sheet of the photohardenable composition is covered with a flexible polymeric film and imagewise exposing the composition through the film using actinic radiation. The polymeric film and unhardened portions of the composition are then stripped away and removed, leaving the imaged relief surface.

However, problems have remained with flexographic printing plates including loss of sharpness in the relief surface caused by the diffraction of the actinic radiation passing through the film layer or mask to the surface of the photohardenable composition and distortion of the rubbery relief surfaces when the plate is mounted onto a plate cylinder for printing. Additionally, as the plates are customized for individual repetitive printing jobs, the printer must maintain a large inventory of the plates typically mounted on a replaceable sleeve, which takes up valuable plant space and increases parts costs to the printer.

Accordingly, needs remain in this art for a printing plate which can be accrurately imaged and readily replaced to provide improved print quality while lowering costs to the printer.

### SUMMARY OF THE INVENTION

The present invention addresses these needs by providing a cylindrical printing plate in the form of a sleeve having a relief imaged surface which is reimagable, that is, the relief image(s) can be removed and new images replaced on the surface. The sleeve may be utilized in flexographic printing processes. Further, with suitable modifications, the sleeve may also be useful in other direct and indirect relief printing processes including offset lithography as well as in intaglio processes such as direct and indirect gravure printing processes.

In accordance with the invention, an expandable, replaceable printing sleeve is provided which comprises a base layer, at least one compressible layer, and a surface layer including a relief-imaged surface, wherein said relief-imaged surface has been formed directly on said surface layer by digital imaging photopolymerization, as defined in claim 1.

The invention also resides in a method of making an expandable, replaceable printing comprising the steps of: providing a sleeve comprising a base layer, at least one compressible layer, and a surface layer, providing a liquid photopolymer on at least a portion of said surface layer; and irradiating said polymer with a light source for a time sufficient to cure said polymer and form a relief image directly on said sleeve.

The invention extends to a digital imaging photopolymerization system comprising a source of a liquid photopolymer, an expandable, replaceable printing sleeve including a base layer, at least one compressible layer, and a surface layer adapted to receive said liquid photopolymer; a source of actinic radiation for irradiating said liquid photopolymer to form a relief image on said sleeve; and a computer for controlling the operation of said system.

The sleeve is a composite of one or more layers of metal, fabric, and/or polymer to provide requisite properties of compressibility and conformability as well as a stable support surface for the raised image, and may take a variety of forms. For replaceability, the sleeve can be mounted and demounted onto a metal cylinder or roller using pressurized air. The sleeve is constructed to provide an inner diameter and shape which is mountable onto a cylinder or roller without slippage during the printing process.

The relief imaged surface is formed using digital imaging photopolymenzation techniques in which liquid photopolymer lalyer is provided on the sleeve and is exposed to a light source which emits radiation for a time sufficient to cure and harden the photopolymer in areas exposed to the radiation. The term "photopolymerization" is meant to include both polymer formation and polymer crosslinking and also includes photohardenable compositions. Preferably, a raised relief image of approximately 0.40 to 1.0 mm is provided. The liquid photopolymer may be any light-sensitive polymer which will cure and harden after exposure to actinic radiation. The photopolymer is preferably selected from the group consisting of acrylates, epoxies, urethanes, and unsaturated polyesters.

In one embodiment of the invention, the relief imaged surface is formed at a digital imaging station using stereolithography techniques. At the imaging station, the sleeve is immersed into a bath of a liquid photopolymer or meterly coated with liquid polymer in a non-immersive manner. The sleeve is rotated so that successive portions of the sleeve which are covered by the photopolymer are exposed to a source of actinic radiation such as a laser which is translated along or across the surface of the sleeve. Alternatively, the laser may be fixed, and the sleeve translated and rotated appropriately. Those portions of the photopolymer which are exposed to the laser cure and form raised image areas. Laser scanning is repeated until the entire surface is imaged.

The resulting printing sleeve may then be mounted onto a press and used to print in a conventional manner. Once the particular printing job for which the image was produced has been completed, the imaged sleeve may be demounted and stored for later reuse. Alternatively, the relief image surface may be removed at a reprocessing station, and the surface of the sleeve prepared for receiving a new image at the digital imaging station. The relief image is preferably removed by an abrading mechanism which mechanically grinds, scrapes, or otherwise cuts away the imaged areas until the surface of the sleeve is exposed. Alternatively, the image may be removed by chemically dissolving and washing away the raised image.

Because the plate is in the form of a replaceable sleeve, the printer need not tie up a printing cylinder for each plate; the sleeves may be readily demounted and stored. Further, as the image on the printing plate is replaceable, the printer need not maintain a large inventory of plates. This reduces costs. Lastly, as the image is formed digitally from a computer stored file, there is no degradation in quality of the image as with masks or film layers so that the image which is printed is sharp and well defined.

Accordingly, it is a feature of the present invention to provide a printing plate and process of manufacture having a digitally formed relief imaged surface which may be utilized in flexographic as well as other printing processes. It is a further feature of the invention to provide a reusable printing plate. These, and other features and advantages of the present invention, will become apparent from the following detailed description, the accompanying drawings, and the appended claims.

### BRIEF DESCRIPTION OF THE DRAWINGS

Fig. 1 is a schematic, perspective view of the composite sleeve prior to imaging;
Fig. 2 is a schematic, perspective view of the printing sleeve after imaging;
Fig. 3 is a schematic diagram of a preferred imaging process for the printing is sleeve at a digital imaging station; and
Fig 4 is a schematic diagram of the removal of the image portion of the printing sleeve at a sleeve reprocessing station.

### DETAILED DESCRIPTION OF THE PREFERRED EMBODIMENT

White the printing plate of the present invention will be described with reference to its preferrect use as a printing plate for use in a flexographic printing process, it will be apparent to those skilled in the art the plate may be modifier for use in other direct and indirect printing processes including intagho and direct and indirect gravure processes.

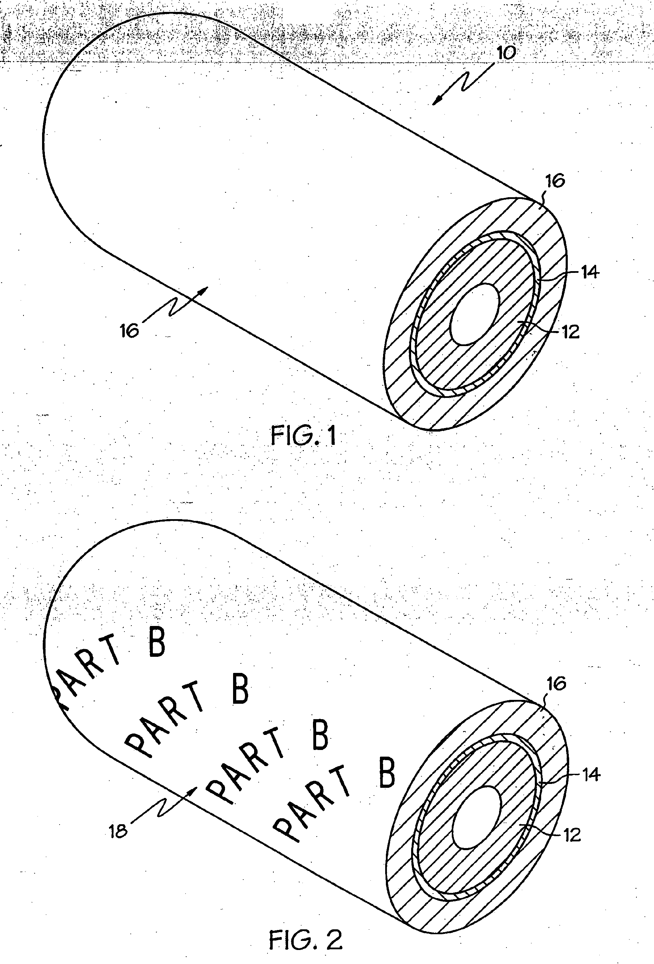

Fig. 1 illustrates one embodiment of the invention in which a schematic of a composite sleeve 10 is shown. The sleeve 10 acts as a support assembly and includes one or more polymer layers including one or more compressible elastomeric layers such as, for example, an inner base polymer layer 12, a compressible layer 14, and a surface layer 16 which provides a stable working surface for the later-applied image-bearing layer. Sleeve 10 is designed to be mounted onto (and demounted from) a cylindrically-shaped roller (not shown) through the use of pressurized air which will cause the sleeve to expand slightly to provide clearance during the mounting and demounting. Once the air pressure is removed, the sleeve 10 will contract tightly about the cylinder and will not slip or slide during printing.

Fig. 2 shows schematically the printing sleeve 10 after an image ("PART B") has been applied to surface 18. The image may take the form of any indicia including numbers, letters, graphics, etc. needed to perform the print job. Genarally, for flexographic applications, the image on surface 18 will have a height of approximately 0.40 to 1.0 mm.

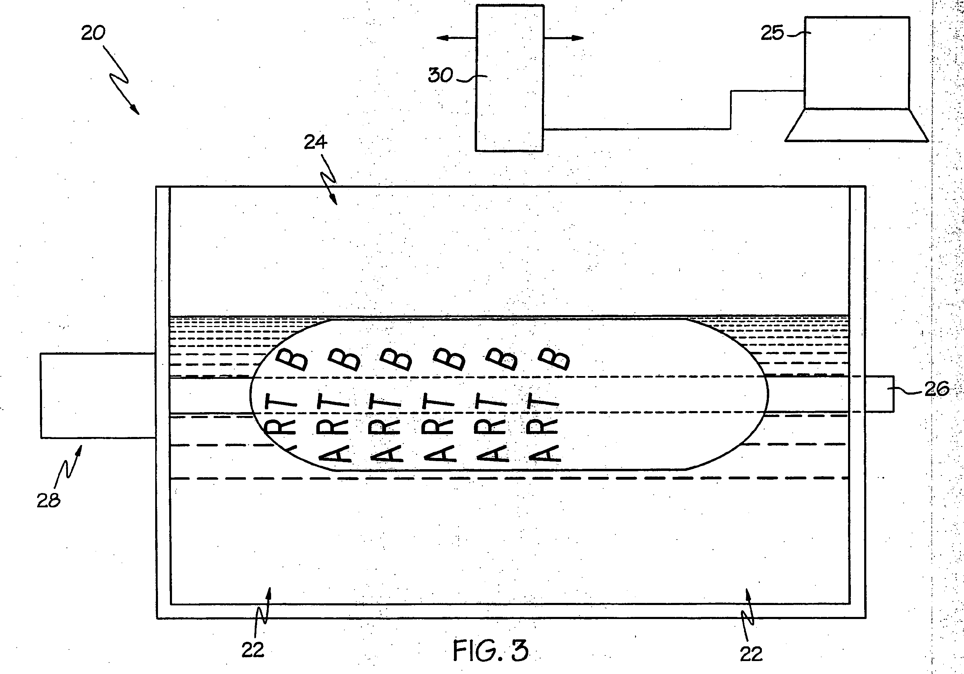

The image is formed on sleeve 10 at a digital imaging station 20 as shown schematically in Fig. 3. There, sleeve 10 is immersed into a bath of a liquid, photopolymer 22 contained in tank 24. Suitable photopolymers are known and are commercially available from a number of companies. Any suitable photocurable or photohardenable resin may be used in the practice of this invention.

As shown, sleeve 10 may be mounted onto a mandrel 26, the long axis of which is rotated by a suitable drive mechanism such as, for example, a stepper motor 28. The level of liquid photopolymer in the bath is such that the upper surface of the sleeve is substantially level with the upper surface of the polymer bath. Actinic radiation to activate and harden the polymer is provided from a source 30 which is preferably a laser light source. However, it will be appreciated that other sources of actinic radiation may be utilized within the scope of the present invention.

Laser 30 is mounted so that it can be translated to irradiate parallel to the long axis of sleeve 10. The beam is modulated under the control of a computer 25 to create a single line of the image to be formed. Computer aided design and drafting software is commercially available from a number of companies and may be used to convert a desired image to be printed into the necessary modulation of the laser beam. After each line of the image is scanned onto the surface of sleeve 10, stepper motor 28 rotates sleeve 10 to position it to receive the next line of information. In this manner, a relief image is built up on surface 18 of the sleeve. Once imaging has been completed, sleeve 10 is removed from the bath, and any excess, unreacted photopolymer is washed away. For extended use, the finished sleeve may be baked to increase its durability.

Upon finishing image sleeve 10 as is conventional in flexographic applications, the sleeve may then be mounted onto a plate cylinder of a flexographic printing press. Because the image is digitally formed directly onto the cylindrical surface of the sleeve 10, there is no distortion of the image, which remains sharp and well defined. Once a printing job has been completed, sleeve 10 may be demounted and stored for later use (if the print job is repetitive).

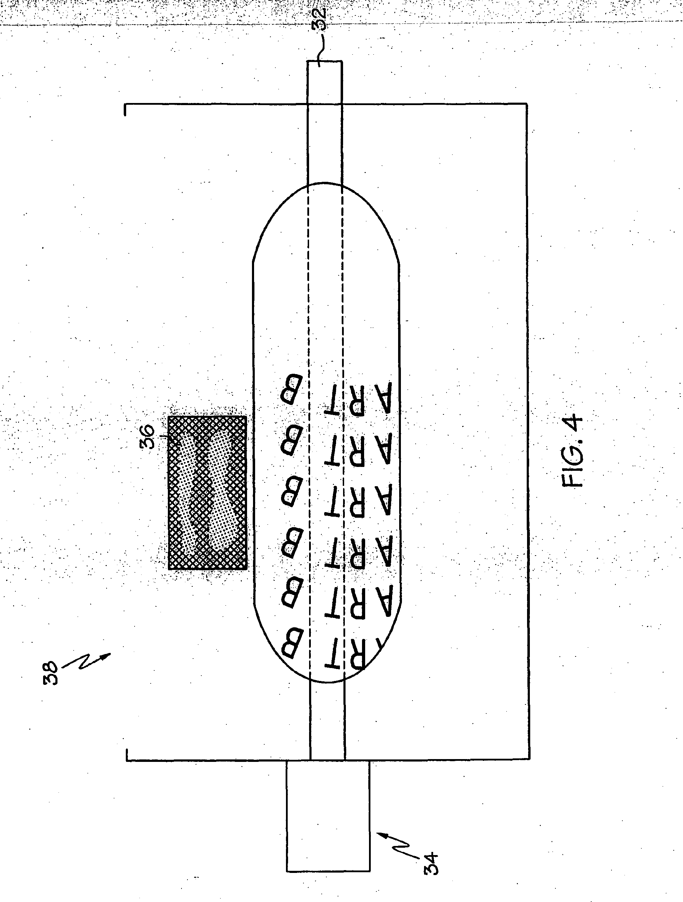

Alternatively, the image on surface 18 may be removed at reprocessing station 38 and sleeve 10 reused as shown in Fig. 4. There, sleeve 10 is mounted onto another mandrel 32 and rotated about its long axis by a suitable drive mechanism 34. The imaged surface 18 is removed by a suitable polymer abrading mechanism 36 which mechanically grinds, scrapes, or cuts away the image until surface layer 16 on sleeve 10 is exposed. Alternatively, the image may be removed by chemically dissolving and washing away the raised image.
The reprocessed sleeve may then be taken back to digital imaging station 20 where a new image is built up as previously described.

Because the images for each printing job may be stored in computer memory, the printer need not stock in inventory multiple printing sleeves or plates. Rather, each printing job may be created and the same sleeve image over and over again. This permits the printer to stock only a minimum number of sleeves, reducing both storage and materials costs. Furthermore, because each print job is digitally imaged directly on the printing sleeve, the print quality is high.

While certain representative embodiments and details have been shown for purposes of illustrating the invention, the invention is defined by the appended claims.

## Claims

1. An expandable, replaceable printing sleeve (10) comprising a base layer (12), at least one compressible layer (14), surface layer (16) which provides a stable working surface and a relief-imaged surface layer (18), wherein said relief-imaged surface layer (18) has been formed directly on said surface layer by digital imaging photopolymerization.

2. A printing sleeve as claimed in claim 1 in which said relief image is from approximately 0.4 to 1.0 mm thick.

3. A printing sleeve as claimed in claim 1 in which said sleeve (10) is reimagable upon removal of said relief-imaged surface.

4. A method of making an expandable, replaceable printing sleeve (10) comprising the steps of:
providing a sleeve (10) comprising a base layer (12), at least one compressible layer (1-4), and a surface layer (16), which provides a stable working surface
providing a liquid photopolymer on at least a portion of said surface layer; and
irradiating said polymer with a light source (30) for a time sufficient to cure said polymer and form a relief image directly on said sleeve (10).

5. A method as claimed in claim 4 in which said photopolymer is prepared from the group consisting of acrylates, epoxies, urethanes, unsaturated polyesters, and mixtures thereof.

6. The method of claim 4 in which said sleeve (10) is immersed into a bath of said liquid photopolymer.

7. The method of claim 4 in which said sleeve (10) is meterly coated with said liquid photopolymer.

8. A method as claimed in claim 4 in which said light source comprises a laser (30).

9. A method as claimed in claim 8 in which said laser (30) is translated over said surface of said sleeve (10) to photopolymerize selected portions of said photopolymer.

10. A method as claimed in claim 4, further including the steps of:
mounting said sleeve (10) on a printing device and printing a substrate using said relief image;
demounting said sleeve (10) from said printing device and removing said relief image from said sleeve (10) such that said sleeve (10) is adapted to receive a new relief imaged surface.

11. The method as claimed in claim 10 in which said relief image is removed by an abrading mechanism (36).

12. The method as claimed in claim 10 in which said relief image is removed by chemically dissolving said relief image.

13. A digital imaging photopolymerization system comprising:
a source of a liquid photopolymer (22);
an expandable, replaceable printing sleeve (10) including a base layer (12), at least one compressible layer (14), and a surface layer (16) adapted to receive said liquid photopolymer and which provides a stable working surface
a source of actinic radiation (30) for irradiating said liquid photopolymer to form a relief image on said sleeve (10); and
a computer (25) for controlling the operation of said system.

14. The digital imaging system of claim 13 in which said source of actinic radiation comprises a laser (30).

## Patentansprüche

1. Dehnbare, auswechselbare Druckhülse (10), die eine Basisschicht (12) aufweist, sowie wenigstens eine zusammendrückbare Schicht (14) und eine Oberflächenschicht (16), die eine stabile Arbeitsfläche darstellt, und eine mit einer Reliefabbildung versehene Oberfläche (18), wobei diese mit einer Reliefabbildung versehene Oberfläche (18) direkt auf dieser Oberflächenschicht durch eine digitale, bilderzeugende Photopolymerisation erzeugt ist.

2. Druckhülse nach Anspruch 1, bei welcher die Reliefabbildung eine Dicke von etwa 0,4 bis 1,0 mm aufweist.

3. Druckhülse nach Anspruch 1, bei der die Hülse (10) nach Entfernung der Reliefabbildung wieder mit einer Abbildung versehen werden kann.

4. Verfahren zur Herstellung einer dehnbaren, auswechselbaren Druckhülse (10) umfassend folgende Schritte:
Vorsehen einer Hülse (10), die eine Basisschicht (1^2) wenigstens eine zusammendrückbare Schicht (14) und eine Oberflächenschicht (16) aufweist, die eine stabile Arbeitsfläche bildet,
Vorsehen eines flüssigen Polymers auf wenigstens einem Teil der Oberflächenschicht und Bestrahlung des Polymers durch eine Lichtquelle (30) während einer Zeitspanne, die ausreichend ist, das Polymer auszuhärten und auf der Hülse (10) eine Reliefabbildung auszubilden.

5. Verfahren nach Anspruch 4, bei welchem das Photopolymer aus der Gruppe gebildet ist, die Acrylate, Epoxydharze, Urethane, ungesättigte Polyester und deren Mischungen umfaßt.

6. Verfahren nach Anspruch 4, bei welchem diese Hülse (10) in ein Bad aus diesem Photopolymer eingetaucht wird.

7. Verfahren nach Anspruch 4, bei welchem diese Hülse (10) dosiert mit dem flüssigen Photopolymer überzogen wird.

8. Verfahren nach Anspruch 4, bei welchem die Lichtquelle einen Laser (30) umfaßt.

9. Verfahren nach Anspruch 8, bei welchem der Laser (30) zur Polymerisation ausgewählter Bereiche des Polymers über die Oberfläche der Hülse (10) geführt wird.

10. Verfahren nach Anspruch 4, weiter umfassend folgende Schritte:
Befestigung der Hülse (10) auf einer Druckvorrichtung und Bedrucken eines Substrats unter Verwendung der Reliefabbildung,
Abnahme der Hülse (10) von der Druckvorrichtung und Entfernung der Reliefabbildung von der Hülse (10) derart, daß die Hülse (10) geeignet ist, eine neue Oberfläche mit Reliefabbildung aufzunehmen.

11. Verfahren nach Anspruch 10, bei welchem die Reliefabbildung durch einen abrasiven Mechanismus (36) entfernt wird.

12. Verfahren nach Anspruch 10, bei welchem die Reliefabbildung durch chemische Auflösung entfernt wird.

13. System zur digitalen bilderzeugenden Photopolymerisation umfassend:
eine Quelle eines flüssigen Photopolymers (22),
eine dehnbare, auswechselbare Druckhülse (10), die eine Basisschicht (12), wenigstens eine zusammendrückbare Schicht (14) und eine Oberflächenschicht (16), die eine stabile Arbeitsfläche darstellt, und geeignet ist, das flüssige Photopolymer aufzunehmen,
eine Quelle (30) einer aktinischen Strahlung zur Bestrahlung des flüssigen Photopolymers zur Ausbildung einer Reliefabbildung auf der Hülse (10) und
einen Computer (25) zur Steuerung der Aktion des Systems.

14. Digitales Abbildungssystem nach Anspruch 13, bei welchem die Quelle der aktinischen Strahlung einen Laser (30) umfaßt.

## Revendications

1. Manchon d'impression remplaçable, dilatable (10) comprenant une couche de base (12), au moins une couche compressible (14), et une couche de surface (16) qui fournit une surface de travail stable et une couche de surface imagée en relief (18), dans lequel ladite couche de surface imagée en relief (18) a été formée directement sur ladite couche de surface par photopolymérisation en imagerie numérique.

2. Manchon d'impression selon la revendication 1, dans lequel ladite image en relief est approximativement comprise entre 0,4 et 1 mm d'épaisseur.

3. Manchon d'impression selon la revendication 1, dans lequel ledit manchon (10) est ré-imageable lors du retrait de ladite surface en relief.

4. Procédé pour fabriquer un manchon d'impression remplaçable, dilatable (10) comprenant les étapes de :
- fournir un manchon (10) comprenant une couche de base (12), au moins une couche compressible (14) et une couche de surface (16) qui fournit une surface de travail stable ;
- fournir un photopolymère liquide sur au moins une partie de ladite couche de surface ; et
- irradier ledit polymère avec une source lumineuse (30) pendant un temps suffisant pour cuire ledit polymère et former une image en relief directement sur ledit manchon (10).

5. Procédé selon la revendication 4, dans lequel ledit photopolymère est préparé à partir d'un groupe consistant en des acrylates, des epoxys, des uréthanes, des polyesters insaturés, et des mélanges de ceux-ci.

6. Procédé selon la revendication 4, dans lequel ledit manchon (10) est immergé dans un bain dudit photopolymère liquide.

7. Procédé selon la revendication 4, dans lequel ledit manchon (10) et revêtu de manière dosée avec ledit photopolymère liquide.

8. Procédé selon la revendication 4, dans lequel ladite source lumineuse comprend un laser (30).

9. Procédé selon la revendication 8, dans lequel ledit laser (30) est translaté sur ladite surface dudit manchon (10) pour photopolymériser des parties sélectionnées dudit photopolymère.

10. Procédé selon la revendication 4, comprenant en outre les étapes de:
- monter ledit manchon (10) sur un dispositif d'impression et d'imprimer un substrat en utilisant ladite image en relief ;
- démonter ledit manchon (10) dudit dispositif d'impression et retirer ladite image en relief dudit manchon (10), de sorte que ledit manchon (10) est adapté à recevoir une nouvelle surface imagée en relief.

11. Procédé selon la revendication 10, dans lequel ladite image en relief est retirée par un mécanisme d'abrasion (36).

12. Procédé selon la revendication 10, dans lequel ladite image en relief est retirée en dissolvant chimiquement ladite image en relief.

13. Système de photopolymérisation en imagerie numérique, comprenant :
- une source d'un photopolymère liquide (22) ;
- un manchon d'impression remplaçable dilatable (10) comprenant une couche de base (12), au moins une couche compressible (14), et une couche de surface (16) adaptée à recevoir ledit photopolymère liquide et qui fournit une surface de travail stable ;
- une source de rayonnement actinique (30) pour irradier ledit photopolymère liquide pour former une image en relief sur ledit manchon (10) ; et
- un ordinateur (25) pour commander le fonctionnement dudit système.

14. Système en imagerie numérique selon la revendication 13, dans lequel ladite source de rayonnement actinique comprend un laser (30).
